# EUROPEAN PATENT APPLICATION

(11) **EP 4 700 981 A1**
(43) Date of publication of application: **25.02.2026**
(21) Application number: 25197452.3
(22) Date of filing: 21.08.2025
(51) Int. Cl.: H01Q 1/22, H01P 5/107, H01Q 13/06, H01Q 21/00

(54) **SEMICONDUCTOR DEVICE WITH HYBRID WAVEGUIDE AND METHOD THEREFOR**

(30) Priority: 22.08.2024 US 202418812131
(71) Applicant: NXP B.V., 5656 AG Eindhoven (NL)
(72) Inventor: MANDAMPARAMBIL, Rajesh, 5656AG Eindhoven (NL); NANDAGOPAL, Harish, 5656AG Eindhoven (NL); SYED, Hassan Waqas, 5656AG Eindhoven (NL); BUIJSMAN, Adrianus, 5656AG Eindhoven (NL); ACAR, Mustafa, 5656AG Eindhoven (NL); BERGMAN, Jan Willem, 5656AG Eindhoven (NL)

(57) **Abstract**

A method of forming a hybrid waveguide semiconductor device is provided. The method includes forming a packaged radio frequency (RF) device and affixing a waveguide structure on the packaged RF device. The waveguide structure includes a non-conductive substrate and an air-filled waveguide formed in the substrate. A radiating element of the packaged RF device includes a pin structure connected to a die pad of a semiconductor die and a hat structure. The pin structure is embedded in an encapsulant of the packaged RF semiconductor device, and the hat structure is exposed within the air-filled waveguide.

## Description

### Background

### Field

This disclosure relates generally to semiconductor device packaging, and more specifically, to semiconductor devices with a hybrid waveguide and method of forming the same.

### Related Art

Today, there is an increasing trend to include sophisticated semiconductor devices in products and systems that are used every day. These sophisticated semiconductor devices may include features for specific applications which may impact the configuration of the semiconductor device packages, for example. For some higher performance features and applications, the configuration of the semiconductor device packages may be susceptible to performance constraints and higher product or system costs. Accordingly, significant challenges exist in accommodating these higher performance features and applications while enabling semiconductor devices' enhanced performance without significant costs impact.

### Brief Description of the Drawings

The present invention is illustrated by way of example and is not limited by the accompanying figures, in which like references indicate similar elements. Elements in the figures are illustrated for simplicity and clarity and have not necessarily been drawn to scale.
FIG. 1 through FIG. 3 illustrate, in simplified cross-sectional views, an example packaged radio frequency (RF) device at stages of manufacture in accordance with an embodiment.
FIG. 4 through FIG. 6 illustrate, in simplified cross-sectional views, an example semiconductor device including the packaged RF device at stages of manufacture in accordance with an embodiment.
FIG. 7 illustrates, in a simplified cross-sectional view, an alternative example semiconductor device including the packaged RF device at a stage of manufacture in accordance with an embodiment.
FIG. 8 and FIG. 9 illustrate, in simplified cross-sectional views, an alternative example packaged RF device at stages of manufacture in accordance with an embodiment.
FIG. 10 illustrates, in a simplified cross-sectional view, an example semiconductor device including the alternative packaged RF device at a stage of manufacture in accordance with an embodiment.
FIG. 11 illustrates, in a simplified cross-sectional view, an alternative example packaged RF device at a stage of manufacture in accordance with an embodiment.
FIG. 12 through FIG. 14 illustrate, in simplified cross-sectional views, an example semiconductor device including the alternative packaged RF device at stages of manufacture in accordance with an embodiment.

### Detailed Description

Generally, there is provided, a semiconductor device having a hybrid waveguide. The semiconductor device includes a waveguide structure mounted on a packaged RF device. The packaged RF device includes a semiconductor die encapsulated with an encapsulant. A radiating element is formed directly connected to a die pad of the semiconductor die. The radiating element includes a "pin" structure portion embedded in the encapsulant and a "hat" structure formed over the encapsulant and connected directly to the pin structure. A signal reflector surrounding the radiating element at the surface of the semiconductor is embedded in the encapsulant. The waveguide structure of the semiconductor device includes an air-filled waveguide embedded in a waveguide substate of the waveguide structure. The waveguide structure is affixed over the active side of the encapsulated semiconductor die such that the hat structure of the radiating element is exposed within the waveguide. The portion of the encapsulant embedding the signal reflector and pin structure together with the air-filled waveguide of the waveguide structure form a hybrid waveguide. By forming the semiconductor device with a hybrid waveguide in this manner, TE10 mode excitation may be achieved with minimal package size and reduced signal losses.

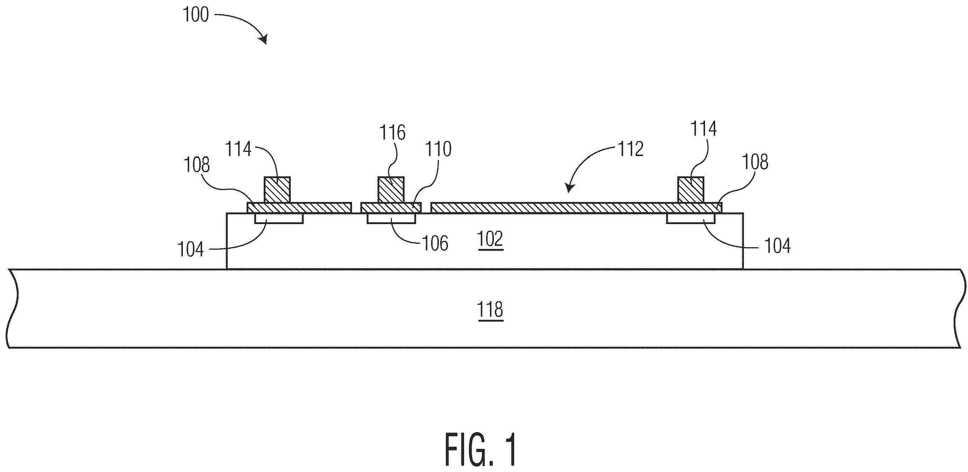

FIG. 1 illustrates, in a simplified cross-sectional view, an example packaged RF device 100 at a stage of manufacture in accordance with an embodiment. At this stage of manufacture, the packaged RF device 100 includes a semiconductor die 102 placed on a carrier substrate 118. The semiconductor die 102 is temporarily affixed to the carrier substrate 118 by way of a releasable adhesive (not shown) at a top side of the carrier substrate, for example. In some embodiments, the semiconductor die 102 placed on a carrier substrate 118 while in wafer form.

The semiconductor die 102 has an active side (e.g., major side having circuitry) and a backside (e.g., major side opposite of the active side). The semiconductor die 102 includes die pads 104 and 106 formed at the active side and connected to circuitry of the semiconductor die. As depicted in FIG. 1, the semiconductor die 102 is configured in an active-side-up orientation with the backside of the semiconductor die adhered to the carrier substrate 118. The semiconductor die 102 may be formed from any suitable semiconductor material, such as silicon, germanium, gallium arsenide, gallium nitride, and the like. The semiconductor die 102 may further include RF circuits, digital circuits, analog circuits, power circuits, memories, processors, the like, and combinations thereof at the active side. In this embodiment, the semiconductor die 102 is characterized as an RF semiconductor die configured to transmit and/or receive RF signals at the die pad 106.

In this embodiment, a conductive layer (e.g., copper) is formed over the active side of the semiconductor die 102 and patterned to form conductive traces 108 and 110. The term "conductive," as used herein, generally refers to electrical conductivity unless otherwise specified. Portions of the conductive traces 108 and 110 are directly connected to respective die pads 104 and 106 of the semiconductor die 102. The conductive trace 108 is dielectrically isolated from the conductive trace 110 and configured as a signal reflector 112 that substantially surrounds the conductive trace 110. The signal reflector 112 may be interconnected with a ground supply terminal at a subsequent stage, for example. In this embodiment, conductive die connectors 114 and 116 (e.g., copper pillars, gold bumps, plated dielectric posts) are formed directly over respective die pads 104 and 106 of the semiconductor die 102 and are conductively connected to respective traces 108 and 110. In this embodiment, the conductive die connector 116 is configured as a "pin" structure portion of a radiating element. The conductive die connector 116 may also be referred to herein as the pin structure 116.

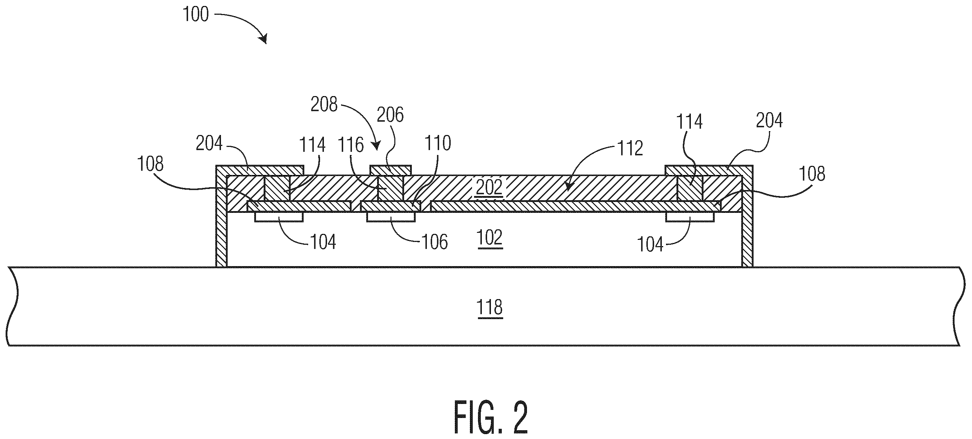

FIG. 2 illustrates, in a simplified cross-sectional view, the example packaged RF device 100 at a subsequent stage of manufacture in accordance with an embodiment. At this stage of manufacture, the packaged RF device 100 includes an encapsulant 202 (e.g., epoxy molding compound) formed over the active side of the semiconductor die 102 and patterned conductive traces 204 and 206 (e.g., copper) formed over portions of the encapsulant. In this embodiment, the semiconductor die 102 is over-molded with the encapsulant 202 by way of a molding process such as a film-assisted molding (FAM) process. For example, a FAM tool using a conformal film may be engaged with a predetermined portion of the die connectors 114 and 116 during the molding process to keep the top surface of the die connectors 114 and 116 free of encapsulant 202. In this manner, the top surface of the die connectors 114 and 116 may be exposed at the top of the encapsulant 202. Alternatively, the semiconductor die 102 may be encapsulated with the encapsulant 202 during an injection molding operation, for example, having the top surface of the die connectors 114 and 116 subsequently exposed at the top of the encapsulant 202 by way of grinding process. In some embodiments, the encapsulant 202 may be formed over the active side of the semiconductor die 102 while in wafer form, then singulated.

After the encapsulant 202 is formed over the semiconductor die 102, conductive traces 204 and 206 are formed. In this embodiment, traces 204 are formed over a portions of the encapsulant 202 and sidewalls of the semiconductor die 102. The traces 204 are configured to directly connect to the exposed top surface of the embedded die connectors 114. Trace 206 is formed to directly connect to the exposed top surface of the embedded pin structure 116. In this embodiment, the encapsulant 202 directly contacts sidewalls of the pin structure 116. In this embodiment, the conductive trace 206 is configured as a "hat" structure portion of the radiating element. The conductive trace 206 may also be referred to herein as the hat structure 206. The hat structure 206 may be formed having a suitable shape (e.g., circular, rectilinear), material (e.g., solder, metal), and size conducive for propagation of high frequency RF signals, for example. In this embodiment, the hat structure 206 together with the pin structure 116 form radiating element 208 configured to transmit and/or receive RF signals. In this embodiment, the signal reflector 112 embedded in the encapsulant 202 is configured to substantially surround the radiating element 208.

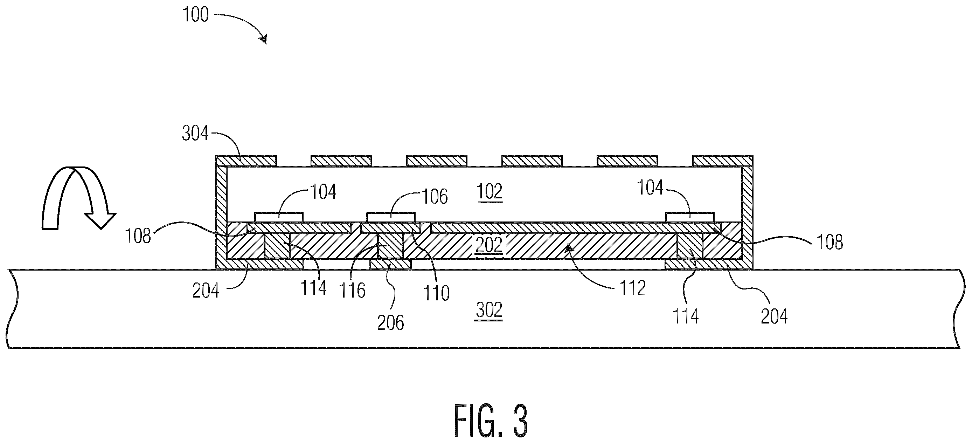

FIG. 3 illustrates, in a simplified cross-sectional view, the example packaged RF device 100 at a subsequent stage of manufacture in accordance with an embodiment. At this stage of manufacture, the packaged RF device 100 includes metal traces 304 formed on the backside of the encapsulated semiconductor die 102. In this embodiment, the encapsulated semiconductor die 102 is separated from the carrier substrate 118, reoriented (e.g., flipped), and placed on a carrier substrate 302 such that the backside of the semiconductor die 102 is exposed for further processing. In this embodiment, a conductive layer (e.g., copper) is formed over the backside of the semiconductor die 102 and patterned to form conductive traces 304. At least a portion of the traces 304 are connected to the traces 204 in this embodiment. The traces 304 may be configured for thermal dissipation, shielding, and/or backside grounding, for example.

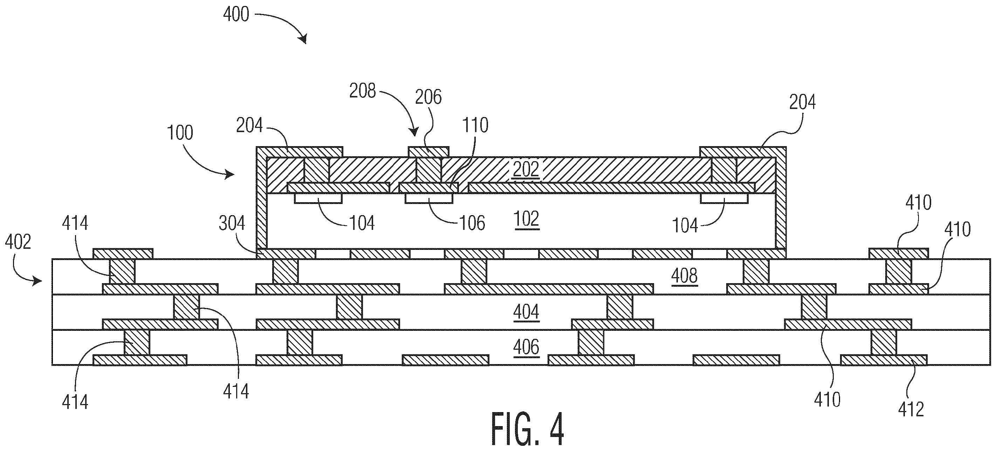

FIG. 4 illustrates, in a simplified cross-sectional view, an example semiconductor device 400 including the packaged RF device 100 at a stage of manufacture in accordance with an embodiment. At this stage of manufacture, the semiconductor device 400 includes a redistribution structure 402 applied over the backside of the packaged RF device 100. In this embodiment, the redistribution structure 402 is provided as a preformed package substrate. The redistribution structure 402 (also referred to herein as "package substrate 402") includes conductive features (e.g., patterned copper traces 410 and 412, vias 414) substantially embeddedin a non-conductive redistribution substrate material (e.g., dielectric layers 404, 406, 408). In the present disclosure, substantially may mean fully; alternatively, depending on the context, it may mean at least in part, the part being more than 50%, or more than 75%, or more than 90%. The redistribution structure 402 may be characterized as a redistribution layer (RDL) substrate having exposed portions of traces 410 and vias 414 at a top surface and exposed portions of traces 412 at a bottom surface, for example. In this embodiment, the exposed portions of the vias 414 are configured for attachment of the packaged RF device 100 and the exposed portions of traces 412 are configured for attachment of conductive connectors (at a subsequent stage of manufacture), for example. The exposed portions of traces 412 may be characterized as conductive connector pads 412. The packaged RF device 100 may be affixed to the redistribution structure 402 by way of solder, conductive adhesive, or nano wire (not shown), for example. In this embodiment, the non-conductive redistribution substrate of the redistribution structure 402 is formed as a laminate structure having a core dielectric layer 404 (e.g., FR4) sandwiched between dielectric layers 406 and 408 (e.g., prepreg).

In some embodiments, the redistribution structure 402 may be formed as a build-up package substrate at a subsequent stage of manufacture. For example, after a packaging encapsulation operation, patterned dielectric and conductive layers may be applied sequentially over exposed pads of the semiconductor device allowing for conductive features of the redistribution structure to be interconnected with the exposed pads in a build-up manner.

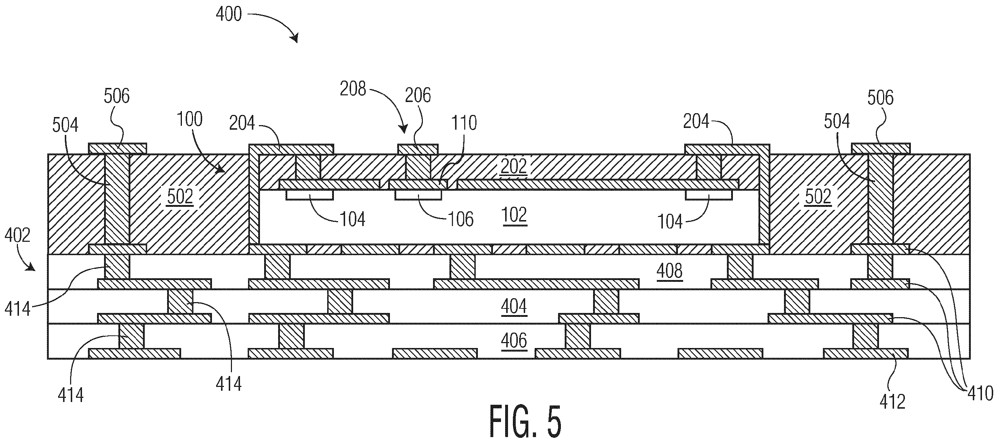

FIG. 5 illustrates, in a simplified cross-sectional view, the example semiconductor device 400 including the packaged RF device 100 at a subsequent stage of manufacture in accordance with an embodiment. At this stage of manufacture, the semiconductor device 400 includes a second encapsulant 502 (e.g., epoxy molding compound) formed over a portion of the redistribution structure 402 and adjacent to an outer perimeter of the packaged RF device 100 affixed to the redistribution structure 402. In this embodiment, the exposed portion of the redistribution structure 402 surrounding the outer perimeter of the packaged RF device 100 is over-molded with the encapsulant 502 by way of a second molding process such as a second FAM process. For example, a FAM tool using a conformal film may be engaged with a predetermined top portion of the packaged RF device 100 during the molding process to keep the top surface of the packaged RF device 100 free of encapsulant 502. In this manner, the top surfaces of the conductive traces 204 and 206 may continue to be exposed after the second molding process.

After the encapsulant 502 is formed over the exposed portion of the redistribution structure 402 surrounding the outer perimeter of the packaged RF device 100, conductive through-mold vias (TMV) 504 and conductive traces 506 are formed. In this embodiment, openings (e.g., holes) are formed through the encapsulant 502 which extend from the top surface of the encapsulant to the underlying portions of traces 410 formed at the top side of the redistribution structure 402. The openings may be formed by way of a suitable process (e.g., etching, laser drilling) and subsequently filled with conductive material (e.g., copper) to form TMVs 504. Alternatively, the conductive vias 504 may be placed onto the redistribution structure 402 before the encapsulant 502 is formed over the exposed portion of the redistribution structure 402 surrounding the outer perimeter of the packaged RF device 100. After forming the TMVs 504, top surface portions of each TMV 504 are exposed at the top surface of the encapsulant 502. Patterned traces 506 are formed over portions of the encapsulant 502 and exposed portions of the TMVs 504. The traces 506 are configured to directly connect to the top surface of the TMVs 504. In this embodiment, at least one continuous conductive path is formed from conductive trace 506 to a connector pad 412 of the redistribution structure 402 by way of a TMV 504.

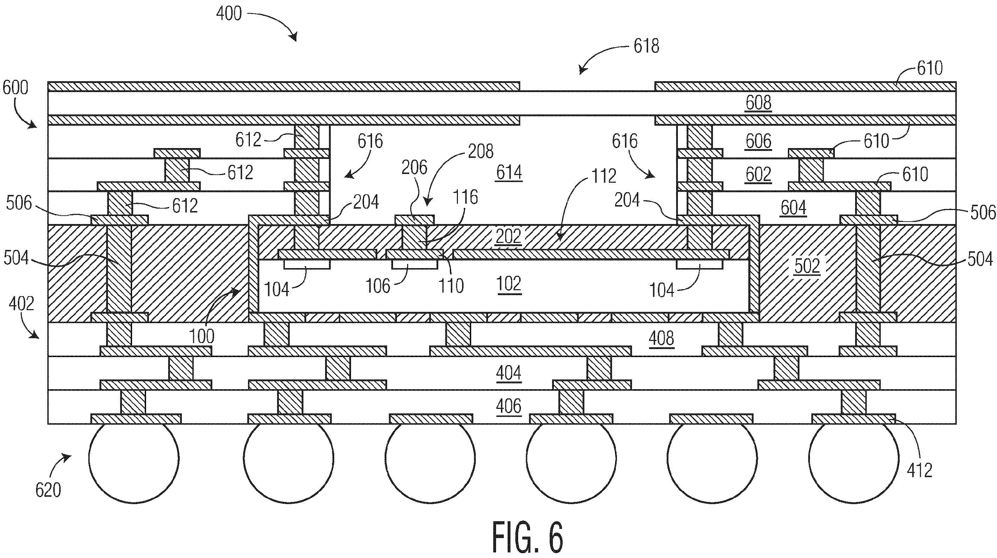

FIG. 6 illustrates, in a simplified cross-sectional view, the example semiconductor device 400 including the packaged RF device 100 at a subsequent stage of manufacture in accordance with an embodiment. At this stage of manufacture, the semiconductor device 400 includes a waveguide structure 600 galvanically affixed at a top major side of the encapsulated redistribution structure 402 and the packaged RF device 100. In this embodiment, patterned conductive traces 610 and vias 612 formed at the bottom side of the waveguide structure 600 are conductively connected to exposed portions of traces 506 and 204. The waveguide structure 600 may be affixed and interconnected with the packaged RF device 100 and redistribution structure 402 by way of solder, conductive adhesive, or nano wire (not shown), for example.

In this embodiment, the waveguide structure 600 includes conductive features (e.g., patterned copper traces 610, vias 612) substantially surrounded by a non-conductive waveguide substrate (e.g., dielectric layers 602, 604, 606, 608), and an air-filled waveguide 614 substantially embedded in the non-conductive waveguide substrate. The waveguide substrate of the waveguide structure 600 may be formed as a laminate structure as depicted in FIG. 6 having a first core dielectric layer 602 (e.g., FR4) sandwiched between dielectric layers 604 and 606 (e.g., prepreg) and a second core dielectric layer 608 (e.g., FR4).

The air-filled waveguide 614 (also referred to herein as "waveguide 614") is formed as a rectangular chamber in the non-conductive waveguide substrate of the waveguide structure 600 in this embodiment. The waveguide 614 is open at the bottom side of the waveguide structure 600 such that the hat structure 206 of the radiating element 208 is exposed within the air-filled waveguide. A conductive fence 616 formed from portions of the traces 610 and vias 612 of the waveguide structure 600 is configured to substantially surround sidewalls of the waveguide 614. Alternatively, a conductive lining (e.g., copper layer) may be formed on sidewalls of the waveguide 614. In this embodiment, a waveguide opening 618 is formed in the conductive traces 610 formed over the waveguide 614 allowing propagation of an RF signal into or out of the waveguide. The dielectric layer 608 encloses the top of the waveguide 614. In this embodiment, a portion of the encapsulant 202 of the packaged RF device 100 between the signal reflector 112 and the top surface of the encapsulant 202 embedding the pin structure 116 together with the air-filled waveguide 614 of the waveguide structure 600 form a hybrid waveguide configured to excite TE10 mode with a minimal package size and reduced signal losses. In this embodiment, the conductive fence 616 is directly connected to traces 204 substantially surround an outer perimeter of the packaged RF device 100 and interconnected with the signal reflector 112 and conductive features of the redistribution structure 402. The conductive fence 616 and signal reflector 112 may be interconnected with a ground supply terminal by way of the redistribution structure 402, for example.

In this embodiment, a plurality of conductive package connectors 620 (e.g., solder balls) are affixed to the bottom side conductive connector pads 412 of the redistribution structure 402. The conductive package connectors 620 are configured and arranged to provide conductive connections between the redistribution structure 402 and a PCB, for example. The conductive package connectors 620 may be in the form of suitable conductive structures such as solder balls, gold studs, copper pillars, and the like, to connect conductive features of the example semiconductor device 400 with the PCB.

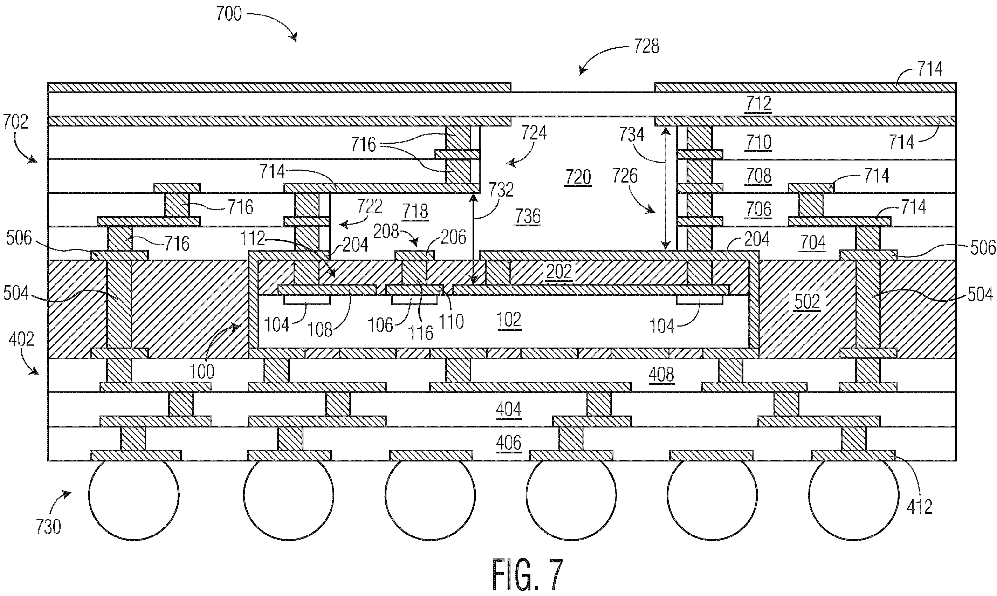

FIG. 7 illustrates, in a simplified cross-sectional view, an alternative example semiconductor device 700 including the packaged RF device 100 at a stage of manufacture in accordance with an embodiment. In this embodiment, the stages of manufacture depicted in FIG. 1 through FIG. 5 remain substantially similar with the packaged RF device 100 and the second encapsulant 502 formed over the redistribution structure 402 adjacent to the packaged RF device 100. At this stage, the semiconductor device 700 includes an alternative waveguide structure 702 galvanically affixed at a top major side of the encapsulated redistribution structure 402 and the packaged RF device 100. In this embodiment, patterned conductive traces 714 and vias 716 formed at the bottom side of the waveguide structure 702 are conductively connected to exposed portions of traces 506 and 204. The waveguide structure 702 may be affixed and interconnected with the packaged RF device 100 and redistribution structure 402 by way of solder, conductive adhesive, or nano wire (not shown), for example.

In this embodiment, the waveguide structure 702 includes conductive features (e.g., patterned copper traces 714, vias 716) substantially surrounded by a non-conductive waveguide substrate (e.g., dielectric layers 704, 706, 708, 710, 712), and an air-filled waveguide 736 substantially embedded in the non-conductive waveguide substrate. The waveguide substrate of the waveguide structure 702 may be formed as a laminate structure as depicted in FIG. 7 having a first core dielectric layer 706 (e.g., FR4) sandwiched between dielectric layers 704 and 708 (e.g., prepreg) and second and third core dielectric layers 710 and 712 (e.g., FR4).

The air-filled waveguide 736 (also referred to herein as "waveguide 736") includes a first rectangular chamber portion 718 (also referred to herein as "chamber 718") formed in the waveguide substrate and a second rectangular chamber portion 720 (also referred to herein as "chamber 720") formed adjacent to the first chamber portion the waveguide substrate in this embodiment. The waveguide 736 is open at the bottom side of the waveguide structure 702 such that the hat structure 206 of the radiating element 208 is exposed within the first chamber 718 of the air-filled waveguide. A conductive fence is formed from portions of the traces 714 and vias 716 of the waveguide structure 702. The conductive fence includes a first conductive fence portion 722 proximate to a portion of the first chamber 718, a second conductive fence portion 724 proximate to a portion of the second chamber 720, and a third conductive fence portion 726. The first conductive fence portion 722, the second conductive fence portion 724, and the third conductive fence portion 726 together are configured to substantially surround sidewalls of the waveguide 736. In this embodiment, a waveguide opening 728 is formed through the conductive traces 714 formed over the second chamber 720 of the waveguide 736 allowing propagation of an RF signal into or out of the waveguide.

The first chamber 718 includes a top conductive trace 714 which forms a conductive lining at the top side of the first chamber 718 and the signal reflector 112 at the bottom side of the first chamber. The first conductive fence portion 722 interconnects the top conductive trace 714 with the signal reflector 112 and laterally surrounds a sidewall portion of the first chamber 718. The first chamber 718 has a first height dimension 732 measured from the top conductive trace 714 to the signal reflector 112. The second chamber 720 includes the dielectric layer 712 and portions of the topmost conductive traces 714 which forms a partial conductive lining at the top side of the second chamber 720 and a second signal reflector formed by trace 204 at the bottom side of the second chamber. In this embodiment, the dielectric layer 712 forms a continuous seal over the top of the second chamber 720 of the waveguide 736. The second conductive fence portion 724 laterally surrounds a sidewall portion of the second chamber 720. The second chamber 720 has a second height dimension 734 measured from the topmost conductive trace 714 to the second signal reflector formed by trace 204. In this embodiment, the first height dimension 732 and the second height dimension 734 are substantially similar. In some embodiments, the first height dimension 732 and the second height dimension 734 may be different. In this embodiment, the second chamber 720 is vertically offset from the first chamber 718.

In this embodiment, a portion of the encapsulant 202 of the packaged RF device 100 between the signal reflector 112 and the top surface of the encapsulant 202 embedding the pin structure 116 together with the air-filled waveguide 736 of the waveguide structure 702 form a hybrid waveguide configured to excite TE10 mode with a minimal package size and reduced signal losses. In this embodiment, the conductive fence portions 722, 724, 726 are interconnected with the signal reflector 112 at the bottom of the first chamber 718 and the second signal reflector formed by trace 204 at the bottom side of the second chamber 720 and may be interconnected with a ground supply terminal by way of the redistribution structure 402, for example.

In this embodiment, a plurality of conductive package connectors 730 (e.g., solder balls) are affixed to the bottom side conductive connector pads 412 of the redistribution structure 402. The conductive package connectors 730 are configured and arranged to provide conductive connections between the redistribution structure 402 and a PCB, for example. The conductive package connectors 730 may be in the form of suitable conductive structures such as solder balls, gold studs, copper pillars, and the like, to connect conductive features of the example semiconductor device 700 with the PCB.

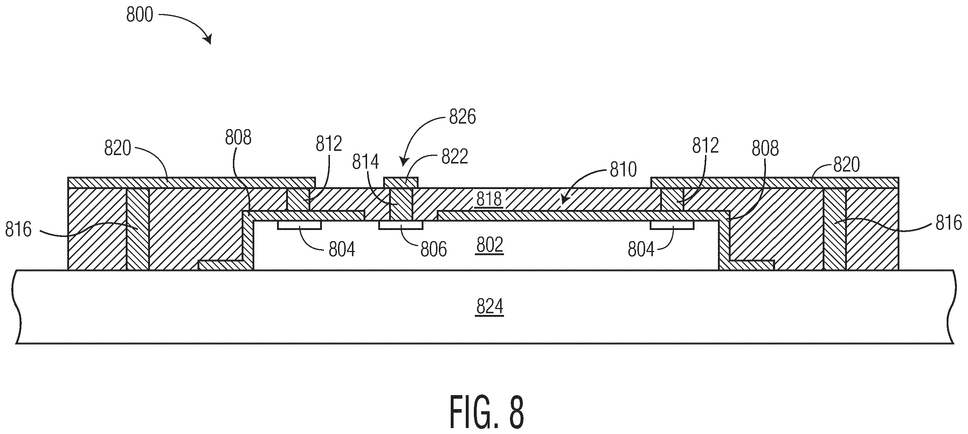

FIG. 8 illustrates, in a simplified cross-sectional view, an alternative example packaged RF device 800 at a stage of manufacture in accordance with an embodiment. At this stage of manufacture, the packaged RF device 800 includes a semiconductor die 802 placed on a carrier substrate 824 and encapsulated with an encapsulant 818 (e.g., epoxy molding compound). The semiconductor die 802 is temporarily affixed to the carrier substrate 524 by way of a releasable adhesive (not shown) at a top side of the carrier substrate, for example.

The semiconductor die 802 has an active side (e.g., major side having circuitry) and a backside (e.g., major side opposite of the active side). The semiconductor die 802 includes die pads 804 and 806 formed at the active side and connected to circuitry of the semiconductor die. As depicted in FIG. 8, the semiconductor die 802 is configured in an active-side-up orientation with the backside of the semiconductor die adhered to the carrier substrate 824. The semiconductor die 802 may be formed from any suitable semiconductor material, such as silicon, germanium, gallium arsenide, gallium nitride, and the like. The semiconductor die 802 may further include RF circuits, digital circuits, analog circuits, power circuits, memories, processors, the like, and combinations thereof at the active side. In this embodiment, the semiconductor die 802 is characterized as an RF semiconductor die configured to transmit and/or receive RF signals at the die pad 806.

In this embodiment, a conformal conductive layer (e.g., copper) is formed over the active side of the semiconductor die 802 and patterned to form conductive trace 808. Portions of the patterned conductive trace 808 are directly connected to respective die pads 804 of the semiconductor die 802 and formed over sidewalls of the semiconductor die 802 and a portion of the carrier substrate 824. The conductive trace 808 is dielectrically isolated from the die pad 806 and configured as a signal reflector 810 that substantially surrounds the die pad 806. The signal reflector 810 may be interconnected with a ground supply terminal at a subsequent stage, for example. Conductive die connectors 812 and 814 (e.g., copper pillars, gold bumps) are formed directly over respective die pads 804 and 806 of the semiconductor die 802. The conductive die connectors 812 are directly connected to the conductive trace 808, for example. In this embodiment, the conductive die connector 814 is configured as a "pin" structure portion of a radiating element 826. The conductive die connector 814 may also be referred to herein as the pin structure 814.

The encapsulant 818 is formed over the active side of the semiconductor die 102, the patterned conductive trace 808, and a portion of the carrier substrate 824 surrounding the semiconductor die. In this embodiment, the semiconductor die 102 may be over-molded with the encapsulant 818 by way of a FAM molding process, for example, to keep the top surface of the die connectors 812 and 814 free of encapsulant 818. In this manner, the top surface of the die connectors 812 and 814 may be exposed at the top of the encapsulant 818.

After the encapsulant 818 is formed, conductive TMVs 816 are formed. In this embodiment, openings (e.g., holes) are formed through the encapsulant 818 which extend from the top surface of the encapsulant to the underlying carrier substrate 824. The openings may be formed by way of a suitable process (e.g., etching, laser drilling) and subsequently filled with conductive material (e.g., copper) to form TMVs 816. After forming the TMVs 816, top surface portions of each TMV 816 are exposed at the top surface of the encapsulant 818. Patterned conductive traces 820 and 822 are subsequently formed over portions of the encapsulant 818 and exposed top surface portions of the TMVs 816 and die connectors 812 and 814. The conductive traces 820 are configured to interconnect the TMVs 816 with respective die connectors 812 and the trace 822 is configured to directly connect to the embedded pin structure 814. In this embodiment, the encapsulant 818 directly contacts sidewalls of the pin structure 814. In this embodiment, the conductive trace 822 is configured as a "hat" structure portion of the radiating element 826. The conductive trace 822 may also be referred to herein as the hat structure 822. The hat structure 822 may be formed having a suitable shape (e.g., circular, rectilinear), material (e.g., solder, metal), and size conducive for propagation of high frequency RF signals, for example. In this embodiment, the hat structure 822 together with the pin structure 814 form radiating element 826 configured to transmit and/or receive RF signals. In this embodiment, the signal reflector 810 embedded in the encapsulant 818 is configured to substantially surround the radiating element 826.

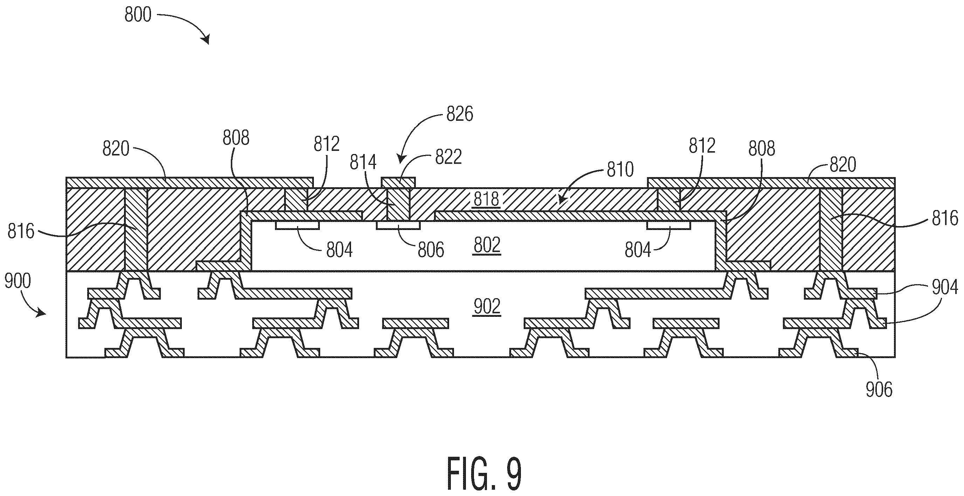

FIG. 9 illustrates, in a simplified cross-sectional view, the alternative example packaged RF device 800 at a subsequent stage of manufacture in accordance with an embodiment. At this stage of manufacture, the packaged RF device 800 includes the encapsulated semiconductor die 802 separated from the carrier substrate and interconnected with a redistribution structure 900. After separating the encapsulated semiconductor die 802 from the carrier substrate, portions of the traces 808 and TMVs 816 are exposed through the encapsulant 818 along with the backside of the semiconductor die 802.

In this embodiment, the redistribution structure 900 is formed a build-up RDL package substrate over the backside of the encapsulated semiconductor die 802 of the packaged RF device 800. The redistribution structure 900 (also referred to herein as "package substrate 900") includes conductive features (e.g., patterned copper traces 904 and 906) substantially embedded in a non-conductive redistribution substrate material (e.g., dielectric 902). For example, patterned dielectric layers (not individually shown) of the dielectric material 902 and patterned conductive layers (e.g., traces 904 and 906) may be applied sequentially over the backside of the encapsulated semiconductor die 802 to interconnect exposed portions of the traces 808 and TMVs 816 with traces 904 and 906 in a build-up manner. The exposed portions of traces 906 of the package substrate 900 are configured for attachment of conductive connectors (at a subsequent stage of manufacture), for example.

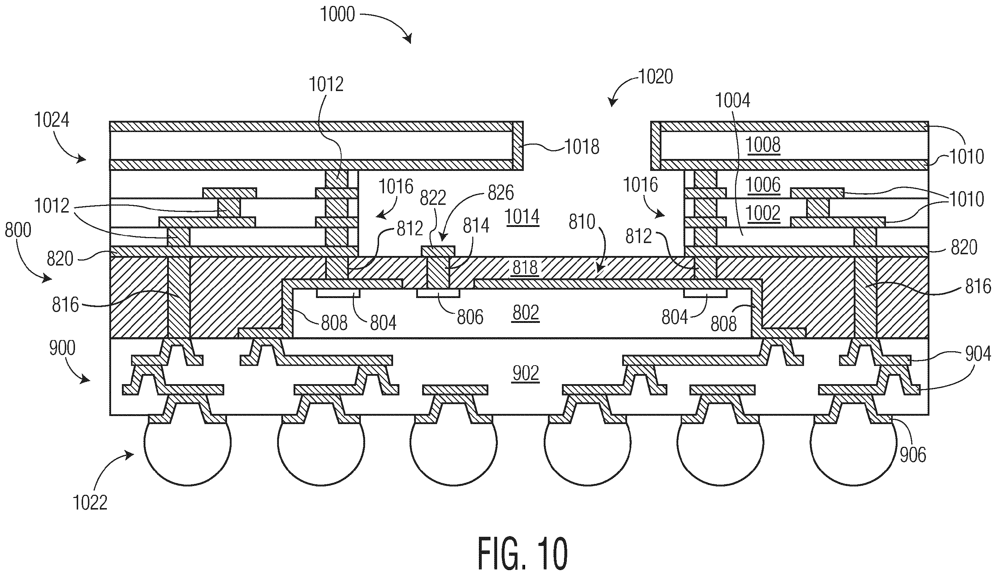

FIG. 10 illustrates, in a simplified cross-sectional view, an example semiconductor device 1000 including the alternative packaged RF device 800 at a stage of manufacture in accordance with an embodiment. At this stage of manufacture, the semiconductor device 1000 includes a waveguide structure 1024 affixed at a top major side of the packaged RF device 800. In this embodiment, patterned conductive traces 1010 and vias 1012 formed at the bottom side of the waveguide structure 1024 are conductively connected to exposed portions of traces 820 of the packaged RF device 800. The waveguide structure 1024 may be affixed and interconnected with the packaged RF device 800 by way of solder, conductive adhesive, or nano wire (not shown), for example.

In this embodiment, the waveguide structure 1024 includes conductive features (e.g., patterned copper traces 1010, vias 1012) substantially surrounded by a non-conductive waveguide substrate (e.g., dielectric layers 1002, 1004, 1006, 1008), and an air-filled waveguide 1014 substantially embedded in the non-conductive waveguide substrate. The waveguide substrate of the waveguide structure 1024 may be formed as a laminate structure as depicted in FIG. 10 having a first core dielectric layer 1002 (e.g., FR4) sandwiched between dielectric layers 1004 and 1006 (e.g., prepreg) and a second core dielectric layer 1008 (e.g., FR4).

The air-filled waveguide 1014 (also referred to herein as "waveguide 1014") is formed as a rectangular chamber in the non-conductive waveguide substrate of the waveguide structure 1024 in this embodiment. The waveguide 1014 is open at the bottom side of the waveguide structure 1024 such that the hat structure 822 of the radiating element 826 is exposed within the air-filled waveguide. A conductive fence 1016 formed from portions of the traces 1010 and vias 1012 of the waveguide structure 1024 is configured to substantially surround sidewalls of the waveguide 1014. In this embodiment, a waveguide opening 1020 is formed through the conductive traces 1010 and dielectric layer 1008 at the top portion of the waveguide. A conductive lining 1018 (e.g., copper) is formed to surround the opening 1020. The opening 1020 formed at the top portion of the waveguide 1014 allows propagation of an RF signal into or out of the waveguide. In this embodiment, a portion of the encapsulant 818 of the packaged RF device 800 between the signal reflector 810 and the top surface of the encapsulant 818 embedding the pin structure 814 together with the air-filled waveguide 1014 of the waveguide structure 1024 form a hybrid waveguide configured to excite TE10 mode with a minimal package size and reduced signal losses. In this embodiment, the conductive fence 1016 is interconnected with traces 808 substantially surrounding an outer perimeter of the semiconductor die 802, the signal reflector 810, and conductive features of the redistribution structure 900. The conductive fence 1016 and signal reflector 810 may be interconnected with a ground supply terminal by way of the redistribution structure 900, for example.

In this embodiment, a plurality of conductive package connectors 1022 (e.g., solder balls) are affixed to the bottom side conductive connector pads 906 of the redistribution structure 900. The conductive package connectors 1022 are configured and arranged to provide conductive connections between the redistribution structure 900 and a PCB, for example. The conductive package connectors 1022 may be in the form of suitable conductive structures such as solder balls, gold studs, copper pillars, and the like, to connect conductive features of the example semiconductor device 1000 with the PCB.

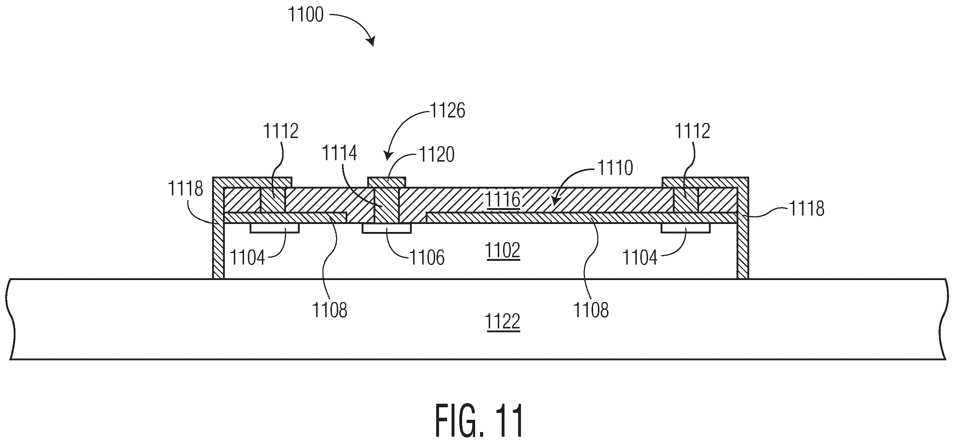

FIG. 11 illustrates, in a simplified cross-sectional view, an alternative example packaged RF device 1100 at a stage of manufacture in accordance with an embodiment. At this stage of manufacture, the packaged RF device 1100 includes a semiconductor die 1102 placed on a carrier substrate 1124 and an encapsulant 1116 (e.g., epoxy molding compound) formed over the active side of the semiconductor die 1102. The semiconductor die 1102 is temporarily affixed to the carrier substrate 1124 by way of a releasable adhesive (not shown) at a top side of the carrier substrate, for example.

The semiconductor die 1102 has an active side (e.g., major side having circuitry) and a backside (e.g., major side opposite of the active side). The semiconductor die 1102 includes die pads 1104 and 1106 formed at the active side and connected to circuitry of the semiconductor die. As depicted in FIG. 11, the semiconductor die 1102 is configured in an active-side-up orientation with the backside of the semiconductor die adhered to the carrier substrate 1124. The semiconductor die 1102 may be formed from any suitable semiconductor material, such as silicon, germanium, gallium arsenide, gallium nitride, and the like. The semiconductor die 1102 may further include RF circuits, digital circuits, analog circuits, power circuits, memories, processors, the like, and combinations thereof at the active side. In this embodiment, the semiconductor die 1102 is characterized as an RF semiconductor die configured to transmit and/or receive RF signals at the die pad 1106.

In this embodiment, a conductive layer (e.g., copper) is formed over the active side of the semiconductor die 102 and patterned to form conductive trace 1108. Portions of the patterned conductive trace 1108 are directly connected to respective die pads 1104 of the semiconductor die 1102. The conductive trace 1108 is dielectrically isolated from the die pad 1106 and configured as a signal reflector 1110 that substantially surrounds the die pad 1106. The signal reflector 1110 may be interconnected with a ground supply terminal at a subsequent stage, for example. Conductive die connectors 1112 and 1114 (e.g., copper pillars, gold bumps) are formed directly over respective die pads 1104 and 1106 of the semiconductor die 1102. The conductive die connectors 1112 are directly connected to the conductive trace 1108, for example. In this embodiment, the conductive die connector 1114 is configured as a "pin" structure portion of a radiating element 1126. The conductive die connector 1114 may also be referred to herein as the pin structure 1114.

The encapsulant 1116 is formed over the active side of the semiconductor die 1102 and the patterned conductive trace 1108 configured as the signal reflector 1110. In this embodiment, the semiconductor die 1102 may be over-molded with the encapsulant 1116 by way of a FAM molding process, for example, to keep the top surface of the die connectors 1112 and 1114 free of encapsulant 1116. In this manner, the top surface of the die connectors 1112 and 1114 may be exposed at the top surface of the encapsulant 1116.

After the encapsulant 1116 is formed over the semiconductor die 1102, patterned conformal conductive traces 1118 and 1120 are formed. In this embodiment, the traces 1118 are formed over a portions of the encapsulant 1116, exposed top surfaces of respective die connectors 1112 and 1114, and sidewalls of the semiconductor die 1102. The traces 1118 are configured to directly connect to the exposed top surface of the embedded die connectors 1112 and trace 1120 is formed to directly connect to the exposed top surface of the embedded pin structure 1114. In this embodiment, the encapsulant 1116 directly contacts sidewalls of the pin structure 1114. In this embodiment, the conductive trace 1120 is configured as a "hat" structure portion of the radiating element 1126. The conductive trace 1120 may also be referred to herein as the hat structure 1120. The hat structure 1120 may be formed having a suitable shape (e.g., circular, rectilinear), material (e.g., solder, metal), and size conducive for propagation of high frequency RF signals, for example. In this embodiment, the hat structure 1120 together with the pin structure 1114 form radiating element 1126 configured to transmit and/or receive RF signals. In this embodiment, the signal reflector 1110 embedded in the encapsulant 1116 is configured to substantially surround the radiating element 1120.

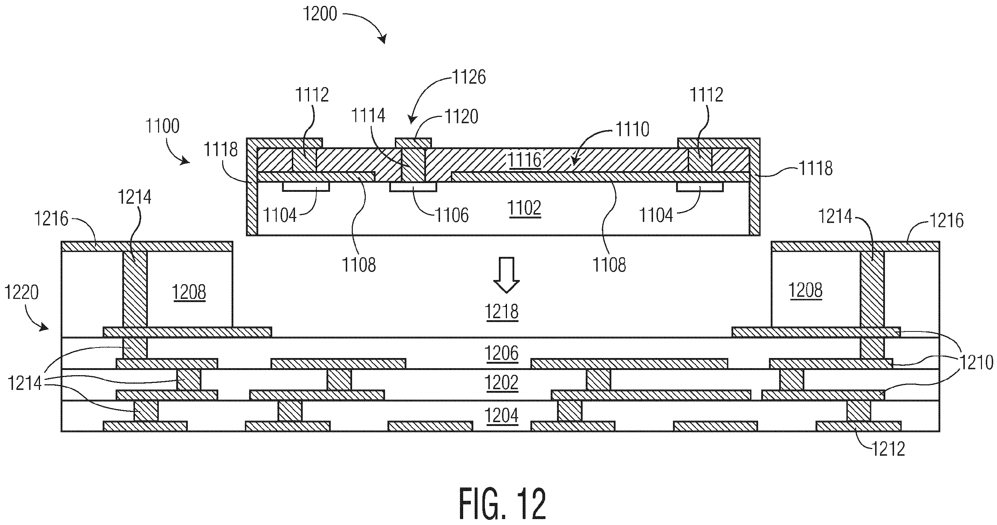

FIG. 12 illustrates, in a simplified cross-sectional view, an example semiconductor device 1200 including the alternative packaged RF device 1100 at a stage of manufacture in accordance with an embodiment. At this stage of manufacture, the semiconductor device 1200 includes the packaged RF device 1100 positioned over a redistribution structure 1220. In this embodiment, the redistribution structure 1220 is provided as a preformed package substrate. The redistribution structure 1220 (also referred to herein as "package substrate 1220") includes conductive features (e.g., patterned copper traces 1210, 1212, 1216, vias 1214) substantially embedded in a non-conductive redistribution substrate material (e.g., dielectric layers 1202, 1204, 1206, 1208). In this embodiment, the redistribution structure 1220 further includes a cavity 1218 configured for placement and attachment of the packaged RF device 1100 (at a subsequent stage). The redistribution structure 1220 may be characterized as a redistribution layer (RDL) package substrate having exposed portions of traces 1210 within the cavity 1218 and exposed portions of traces 1212 at a bottom surface, for example. In this embodiment, the exposed portions of traces 1210 are configured for interconnection with the packaged RF device 1100 and the exposed portions of traces 1212 are configured for attachment of conductive connectors (at subsequent stages of manufacture), for example. The exposed portions of traces 1212 may be characterized as conductive connector pads 1212.

In this embodiment, the non-conductive redistribution substrate of the redistribution structure 1220 is formed as a laminate structure having a core dielectric layer 1202 (e.g., FR4) sandwiched between dielectric layers 1204 and 1206 (e.g., prepreg) and a second core dielectric layer 1208 (e.g., FR4). The dielectric layer 1208 may be formed as a homogenous single dielectric layer or laminate having multiple dielectric layers. In this embodiment, the cavity 1218 is formed in the dielectric layer 1208. Through vias 1214 are formed interconnecting traces 1210 with traces 1216, for example. In some embodiments, the dielectric layer 1208 may be formed as an encapsulant (e.g., epoxy molding compound) on the underlying portion of the non-conductive redistribution substrate having TMVs formed through the encapsulant interconnecting traces 1210 with traces 1216, for example.

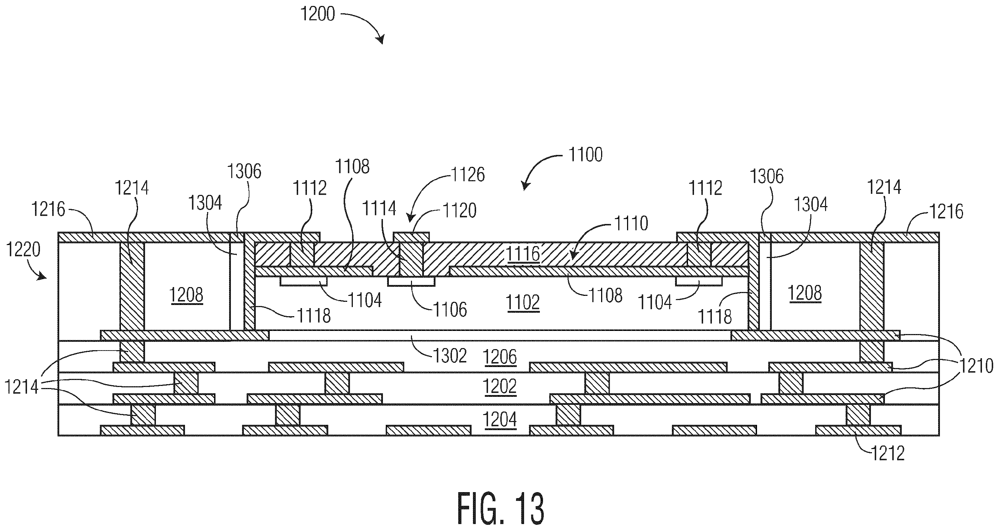

FIG. 13 illustrates, in a simplified cross-sectional view, the example semiconductor device 1200 including the alternative packaged RF device 1100 at a subsequent stage of manufacture in accordance with an embodiment. At this stage of manufacture, the semiconductor device 1200 includes the packaged RF device 1100 mounted within the cavity of the redistribution structure 1220. In this embodiment, the packaged RF device 1100 may be affixed to the bottom of the cavity 1218 (of FIG. 12) of the redistribution structure 1220 by way of a conductive adhesive 1302. The conductive adhesive 1302 is configured to provide a conductive connection between the exposed portions of traces 1210 (within the cavity) and traces 1118 of the packaged RF device 1100, for example. In other embodiments, other materials (solder, solder paste, nano wires) may be used to form conductive connections between the exposed portions of traces 1210 and traces 1118. A gap between sidewalls of the packaged RF device 1100 and sidewalls of the cavity 1218 (of FIG. 12) of the redistribution structure 1220 may be filled by a conductive or non-conductive material 1304 (e.g., glue, paste, gel, epoxy) allowing a subsequently formed conductive trace segment 1306 to interconnect traces 1118 at the top of the packaged RF device 1100 with the traces 1216 at the top of the redistribution structure 1220.

After mounting the packaged RF device 1100 in the cavity of the redistribution structure 1220, the top surface of the encapsulant 1116 is substantially coplanar with the top surface of the dielectric layer 1208. Likewise, the top surfaces of the traces 1118 at the top of the packaged RF device 1100 is substantially coplanar with the top surfaces of the traces 1216 of the redistribution structure 1220.

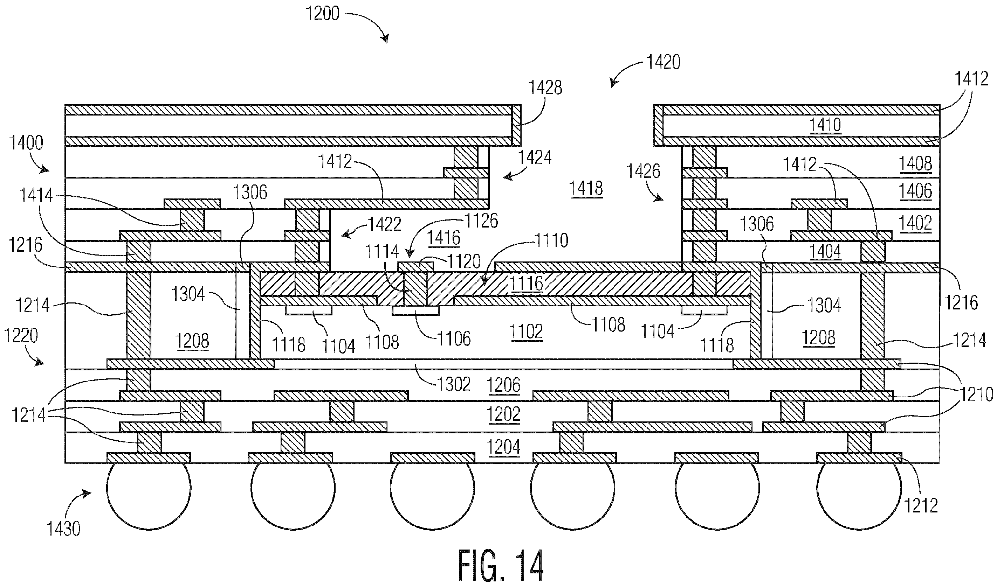

FIG. 14 illustrates, in a simplified cross-sectional view, the example semiconductor device 1200 including the alternative packaged RF device 1100 at a subsequent stage of manufacture in accordance with an embodiment. At this stage of manufacture, the semiconductor device 1200 includes a waveguide structure 1400 affixed at a top major side of the packaged RF device 1100 mounted within the cavity of the redistribution structure 1220. In this embodiment, the exposed vias 1414 formed at the bottom side of the waveguide structure 1400 are conductively connected to portions of exposed traces 1216 and 1118. The waveguide structure 1400 may be affixed and interconnected with the packaged RF device 1100 and redistribution structure 1220 by way of solder, conductive adhesive, or nano wire (not shown), for example.

In this embodiment, the waveguide structure 1400 includes conductive features (e.g., patterned copper traces 1412, vias 1414) substantially surrounded by a non-conductive waveguide substrate (e.g., dielectric layers 1402, 1404, 1406, 1408, 1410), and an air-filled waveguide substantially embedded in the non-conductive waveguide substrate. The waveguide substrate of the waveguide structure 1400 may be formed as a laminate structure as depicted in FIG. 14 having a first core dielectric layer 1402 (e.g., FR4) sandwiched between dielectric layers 704 and 706 (e.g., prepreg) and second and third core dielectric layers 1408 and 1410 (e.g., FR4).

The air-filled waveguide of the waveguide structure 1400 includes a first rectangular chamber portion 1416 (also referred to herein as "chamber 1416") formed in the waveguide substrate and a second rectangular chamber portion 1418 (also referred to herein as "chamber 1418") formed adjacent to the first chamber portion the waveguide substrate in this embodiment. The waveguide is open at the bottom side of the waveguide structure 1400 such that the hat structure 1120 of the radiating element 1126 is exposed within the first chamber 1416 of the air-filled waveguide. A conductive fence is formed from portions of the traces 1412 and vias 1414 of the waveguide structure 1400. The conductive fence includes a first conductive fence portion 1422 proximate to a portion of the first chamber 1416, a second conductive fence portion 1424 proximate to a portion of the second chamber 1418, and a third conductive fence portion 1426. The first conductive fence portion 1422, the second conductive fence portion 1424, and the third conductive fence portion 1426 together are configured to substantially surround sidewalls of the air-filled waveguide of the waveguide structure 1400. In this embodiment, a waveguide opening 1420 is formed through the conductive traces 1412 and dielectric layer 1410 at the top portion of the second chamber 1418 of the waveguide. A conductive lining 1428 (e.g., copper) is formed to surround the opening 1420. The opening 1420 formed at the top portion of the waveguide allows propagation of an RF signal into or out of the waveguide, for example.

The first chamber 1416 includes a top conductive trace 1412 which forms a conductive lining at the top side of the first chamber 1416 and the signal reflector 1110 embedded in the encapsulant 1116 at the bottom side of the first chamber. The first conductive fence portion 1422 interconnects the top conductive trace 1412 with the signal reflector 1110 and laterally surrounds a sidewall portion of the first chamber 1416. The second chamber 1418 includes portions of the topmost conductive traces 1412 surrounding the opening 1420 forming a partial conductive lining at the top side of the second chamber 1418 and a second signal reflector formed by trace 1118 exposed at the bottom side of the second chamber. The second conductive fence portion 1424 laterally surrounds a sidewall portion of the second chamber 1418. In this embodiment, the second chamber 1418 is vertically offset from the first chamber 1416.

In this embodiment, a portion of the encapsulant 1116 of the packaged RF device 1100 between the signal reflector 1110 and the top surface of the encapsulant 1116 embedding the pin structure 1120 together with the air-filled waveguide of the waveguide structure 1400 form a hybrid waveguide configured to excite TE10 mode with a minimal package size and reduced signal losses. In this embodiment, the conductive fence portions 1422, 1424, 1426 are interconnected with the signal reflector 1110 at the bottom of the first chamber 1416 and the second signal reflector formed by trace 1118 at the bottom side of the second chamber 1418 and may be interconnected with a ground supply terminal by way of the redistribution structure 1220, for example.

In this embodiment, a plurality of conductive package connectors 1430 (e.g., solder balls) are affixed to the bottom side conductive connector pads 1212 of the redistribution structure 1220. The conductive package connectors 1430 are configured and arranged to provide conductive connections between the redistribution structure 1220 and a PCB, for example. The conductive package connectors 1430 may be in the form of suitable conductive structures such as solder balls, gold studs, copper pillars, and the like, to connect conductive features of the example semiconductor device 1200 with the PCB.

Generally, there is provided, a method including forming a packaged radio frequency (RF) device, the packaged RF device comprising: a semiconductor die, a radiating element connected to a first die pad of the semiconductor die, the radiating element including a pin structure and a hat structure, and an encapsulant encapsulating at least a portion of the semiconductor die, the pin structure embedded in encapsulant; and affixing a waveguide structure on a first major side of the packaged RF device, the waveguide structure comprising: a non-conductive waveguide substrate, and an air-filled waveguide formed in the non-conductive waveguide substrate, the hat structure exposed within the air-filled waveguide. The method may further include applying a redistribution structure over a second major side of the packaged RF device, the redistribution structure including a non-conductive redistribution substrate and a plurality of conductive traces embedded in the non-conductive redistribution substrate. The packaged RF device may further include a conductive trace formed over a portion of an active side of the semiconductor die, the conductive trace embedded in the encapsulant and configured as a signal reflector of the radiating element. The waveguide structure may further include a conductive fence formed from one or more conductive traces of the plurality of conductive traces and one or more vias interconnecting the one or more conductive traces, the conductive fence at least partially embedded in the non-conductive waveguide substrate and configured to substantially surround the air-filled waveguide. The waveguide structure may be configured to propagate an RF signal through a top portion of the non-conductive waveguide substrate. The method of claim 1, wherein the waveguide structure may further include an opening formed through a top portion of the non-conductive waveguide substrate, the air-filled waveguide of the waveguide structure configured for propagation of an RF signal through the opening. The air-filled waveguide of the waveguide structure may include a first chamber portion and a second chamber portion adjacent to the first chamber portion, the hat structure exposed within the first chamber portion. The second chamber portion may be vertically offset from the first chamber portion. The air-filled waveguide of the waveguide structure may be configured for TE10 mode of propagation of an RF signal.

In another embodiment, there is provided, a semiconductor device including a packaged radio frequency (RF) device, the packaged RF device comprising: a semiconductor die, a radiating element connected to a first die pad of the semiconductor die, the radiating element including a pin structure and a hat structure, and an encapsulant encapsulating at least a portion of the semiconductor die, the pin structure embedded in encapsulant; and a waveguide structure affixed on a first major side of the packaged RF device, the waveguide structure comprising: a non-conductive waveguide substrate, and an air-filled waveguide formed in the non-conductive waveguide substrate, the hat structure exposed within the air-filled waveguide. The semiconductor device may further include a redistribution structure applied over a second major side of the packaged RF device, the redistribution structure including a non-conductive redistribution substrate and a plurality of conductive traces embedded in the non-conductive redistribution substrate. The packaged RF device may further include a conductive trace formed over a portion of an active side of the semiconductor die, the conductive trace embedded in the encapsulant and configured as a signal reflector of the radiating element. The waveguide structure may further include a conductive fence formed from one or more conductive traces of the plurality of conductive traces and one or more vias interconnecting the one or more conductive traces, the conductive fence at least partially embedded in the non-conductive waveguide substrate and configured to substantially surround the air-filled waveguide. The air-filled waveguide of the waveguide structure may include a first rectangular chamber portion and a second rectangular chamber portion contiguous with the first rectangular chamber portion, the hat structure exposed within the first rectangular chamber portion. The second rectangular chamber portion may be vertically offset from the first rectangular chamber portion.

In yet another embodiment, there is provided, a method including forming a packaged radio frequency (RF) device, the packaged RF device comprising: a semiconductor die having a first die pad at an active side, a radiating element directly connected to the first die pad of the semiconductor die, the radiating element including a pin structure and a hat structure, and an encapsulant encapsulating at least a portion of the semiconductor die, the pin structure embedded in encapsulant; and affixing a waveguide structure on a first major side of the packaged RF device, the waveguide structure comprising: a non-conductive laminate waveguide substrate, and an air-filled waveguide formed in the non-conductive laminate waveguide substrate, the hat structure exposed within the air-filled waveguide. The method of claim 16, wherein the packaged RF device may further include a conductive trace formed over a portion of the active side of the semiconductor die and configured as a signal reflector of the radiating element, the conductive trace interconnected with a second die pad of the semiconductor die. The waveguide structure may further include a conductive fence formed from one or more conductive traces of the plurality of conductive traces and one or more vias interconnecting the one or more conductive traces, the conductive fence at least partially embedded in the non-conductive waveguide substrate and configured to substantially surround the air-filled waveguide. The waveguide structure may further include an opening formed through a top portion of the non-conductive laminate waveguide substrate, the air-filled waveguide of the waveguide structure configured for propagation of an RF signal through the opening. The air-filled waveguide of the waveguide structure may include a first rectangular chamber portion and a second rectangular chamber portion contiguous with the first rectangular chamber portion.

By now, it should be appreciated that there has been provided, a semiconductor device having a hybrid waveguide. The semiconductor device includes a waveguide structure mounted on a packaged RF device. The packaged RF device includes a semiconductor die encapsulated with an encapsulant. A radiating element is formed directly connected to a die pad of the semiconductor die. The radiating element includes a "pin" structure portion embedded in the encapsulant and a "hat" structure formed over the encapsulant and connected directly to the pin structure. A signal reflector surrounding the radiating element at the surface of the semiconductor is embedded in the encapsulant. The waveguide structure of the semiconductor device includes an air-filled waveguide embedded in a waveguide substate of the waveguide structure. The waveguide structure is affixed over the active side of the encapsulated semiconductor die such that the hat structure of the radiating element is exposed within the waveguide. The portion of the encapsulant embedding the signal reflector and pin structure together with the air-filled waveguide of the waveguide structure form a hybrid waveguide. By forming the semiconductor device with a hybrid waveguide in this manner, TE10 mode excitation may be achieved with minimal package size and reduced signal losses.

The terms "front," "back," "top," "bottom," "over," "under" and the like in the description and in the claims, if any, are used for descriptive purposes and not necessarily for describing permanent relative positions. It is understood that the terms so used are interchangeable under appropriate circumstances such that the embodiments of the invention described herein are, for example, capable of operation in other orientations than those illustrated or otherwise described herein.

Although the invention is described herein with reference to specific embodiments, various modifications and changes can be made without departing from the scope of the present invention as set forth in the claims below. Accordingly, the specification and figures are to be regarded in an illustrative rather than a restrictive sense, and all such modifications are intended to be included within the scope of the present invention. Any benefits, advantages, or solutions to problems that are described herein with regard to specific embodiments are not intended to be construed as a critical, required, or essential feature or element of any or all the claims.

Furthermore, the terms "a" or "an," as used herein, are defined as one or more than one. Also, the use of introductory phrases such as "at least one" and "one or more" in the claims should not be construed to imply that the introduction of another claim element by the indefinite articles "a" or "an" limits any particular claim containing such introduced claim element to inventions containing only one such element, even when the same claim includes the introductory phrases "one or more" or "at least one" and indefinite articles such as "a" or "an." The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements.

## Claims

1. A method comprising:
forming a packaged radio frequency, RF, device, the packaged RF device comprising:
a semiconductor die,
a radiating element connected to a first die pad of the semiconductor die, the radiating element including a pin structure and a hat structure, and
an encapsulant encapsulating at least a portion of the semiconductor die, the pin structure embedded in encapsulant; and
affixing a waveguide structure on a first major side of the packaged RF device, the waveguide structure comprising:
a non-conductive waveguide substrate, and
an air-filled waveguide formed in the non-conductive waveguide substrate, the hat structure exposed within the air-filled waveguide.

2. The method of claim 1, further comprising:
applying a redistribution structure over a second major side of the packaged RF device, the redistribution structure including a non-conductive redistribution substrate and a plurality of conductive traces embedded in the non-conductive redistribution substrate.

3. The method of claim 1 or 2, wherein the packaged RF device further comprises:
a conductive trace formed over a portion of an active side of the semiconductor die, the conductive trace embedded in the encapsulant and configured as a signal reflector of the radiating element.

4. The method of any preceding claim, wherein the waveguide structure further comprises:
a conductive fence formed from one or more conductive traces of the plurality of conductive traces and one or more vias interconnecting the one or more conductive traces, the conductive fence at least partially embedded in the non-conductive waveguide substrate and configured to surround, or to substantially surround, the air-filled waveguide.

5. The method of any preceding claim, wherein the waveguide structure is configured to propagate an RF signal through a top portion of the non-conductive waveguide substrate.

6. The method of any preceding claim, wherein the waveguide structure further comprises:
an opening formed through a top portion of the non-conductive waveguide substrate, the air-filled waveguide of the waveguide structure configured for propagation of an RF signal through the opening.

7. The method of any preceding claim, wherein the air-filled waveguide of the waveguide structure includes a first chamber portion and a second chamber portion adjacent to the first chamber portion, the hat structure exposed within the first chamber portion.

8. The method of claim 7, wherein the second chamber portion is vertically offset from the first chamber portion.

9. The method of any preceding claim 1, wherein the air-filled waveguide of the waveguide structure is configured for TE10 mode of propagation of an RF signal.

10. A semiconductor device comprising:
a packaged radio frequency, RF, device, the packaged RF device comprising:
a semiconductor die,
a radiating element connected to a first die pad of the semiconductor die, the radiating element including a pin structure and a hat structure, and
an encapsulant encapsulating at least a portion of the semiconductor die, the pin structure embedded in encapsulant; and
a waveguide structure affixed on a first major side of the packaged RF device, the waveguide structure comprising:
a non-conductive waveguide substrate, and
an air-filled waveguide formed in the non-conductive waveguide substrate, the hat structure exposed within the air-filled waveguide.

11. The semiconductor device of claim 10, further comprising a redistribution structure applied over a second major side of the packaged RF device, the redistribution structure including a non-conductive redistribution substrate and a plurality of conductive traces embedded in the non-conductive redistribution substrate.

12. The semiconductor device of claim 10 or 11, wherein the packaged RF device further comprises a conductive trace formed over a portion of an active side of the semiconductor die, the conductive trace embedded in the encapsulant and configured as a signal reflector of the radiating element.

13. The semiconductor device of any of claims 10 to 12, wherein the waveguide structure further comprises a conductive fence formed from one or more conductive traces of the plurality of conductive traces and one or more vias interconnecting the one or more conductive traces, the conductive fence at least partially embedded in the non-conductive waveguide substrate and configured to substantially surround the air-filled waveguide.

14. The semiconductor device of any or claims 10 to 13, wherein the air-filled waveguide of the waveguide structure includes a first rectangular chamber portion and a second rectangular chamber portion contiguous with the first rectangular chamber portion, the hat structure exposed within the first rectangular chamber portion.

15. The semiconductor device of claim 14, wherein the second rectangular chamber portion is vertically offset from the first rectangular chamber portion.
